# EUROPEAN PATENT SPECIFICATION

(11) **EP 0 397 186 B1**
(45) Date of publication and mention of the grant of the patent: **03.04.1996**
(21) Application number: 90108889.8
(22) Date of filing: 11.05.1990
(51) Int. Cl.: H01L 39/22, H01L 39/24

(54) **Superconducting device and manufacturing method thereof**
Supraleitende Einrichtung und deren Herstellungsverfahren
Dispositif supraconducteur et méthode pour sa fabrication

(30) Priority: 12.05.1989 JP 118944/89
(43) Date of publication of application: 14.11.1990
(73) Proprietor: MATSUSHITA ELECTRIC INDUSTRIAL CO., LTD., Kadoma-shi, Osaka-fu, 571 (JP)
(72) Inventor: Higashino, Hidetaka, Matsubara-shi, Osaka-fu (JP); Mizuno, Koichi, Nara-shi, Nara (JP); Setsune, Kentaro, Sakai-shi, Osaka-fu (JP)
(74) Representative: Eisenführ, Speiser & Partner

(56) References cited:
- US-A- 4 157 555
- ELEKTRIE, vol. 42, no. 6, 1988, page 229, Berlin, DE; "Leistungfähiges Josephson-Element auf Keramikbasis"
- IBM TECHNICAL DISCLOSURE BULLETIN, vol. 27, no. 10A, March 1985, pages 5671- 5672, New York, US; "Josephson microbridge with improved heat sink"
- IEEE TRANSACTIONS ON MAGNETICS, vol. 25, no. 2, March 1989, pages 927-930, New York, US; T. KOBAYASHI et al.: "Three terminal YBaCuO Josephson device with quasi-particle injection gate"
- JAPANESE JOURNAL OF APPLIED PHYSICS, vol. 21, suppl. 1, 1982, pages 331-336, Tokyo, JP; S. SAKAI et al.: "Quasiparticle-injected superconducting weak link device"

## Description

### BACKGROUND OF THE INVENTION

### FIELD OF THE INVENTION

The present invention relates to a superconducting device which can control the critical current and a manufacturing method thereof.

### PRIOR ART

Superconducting materials are available for manufacturing a superconducting device which can control the critical current.

Such materials were limited for a long time to those which need to be cooled by liquid helium (boiling point 4.2 K) of high cost and hard to be handled. For example, they include metals such as lead and niobium, metallic compounds such as NbN, Nb₃Ge and Chevrel compounds, and metallic oxide such as Ba-Pb-Bi-O (BPBO) and Ba-K-Bi-O (BKBO). On the other hand, some oxide superconductors including copper are discovered recently to have a high T_{c} above 100 K, and they become superconducting only by using liquid nitrogen (boiling point 77.3 K) of low cost as a coolant. Thus, a superconducting device which can be operated at liquid nitrogen temperatures becomes available, and the are area for applying a superconducting device can be expanded.

A superconducting triode as described e.g. in Phys. Rev. Lett. Vol. 37, 150 (1976) by Wong, T.-W., Yeh, J.T.C. and Langenberg, D.N. as well as in IEEE Trans. Magn., Vol. 13, 743 (1977), one of superconducting devices which can control the superconducting current, comprises a narrow strip of superconducting thin film made of for example a metallic superconducting material Nb and a metallic electrode arranged almost perpendicularly to the narrow strip so as to make contact with each other on the whole surface of the crossing or overlapping region. The superconducting triode controls the superconducting current by injecting quasiparticles into the superconducting thin film from the metallic electrode so as to form a nonequilibrium superconducting region to weaken the superconducting state in the crossing region.

However, a prior art superconducting triode cannot control the width of the superconducting current path though it can control the superconducting current by the injection of quasiparticles in the whole crossing area. Thus, if the width of the superconducting current path is much larger than the coherence length, a superconducting triode cannot operate as a weak-coupling bridge so that the AC Josephson effect cannot be observed.

Further, if a high-T_{c} oxide superconductor is used for a superconducting triode as described e.g. by Kobayashi, T., Hashimoto, K., Kabasawa, U., and Tonouchi, M., in "Three terminal YBaCu0 Josephson device with quasi-particle injection gate", IEEE Trans. Magn., Vol. 25, No. 2, March 1989, pp 927 - 930, where a whole surface of the crossing area of the bridge is covered by a single control electrode, the mechanism which causes the superconductivity has not yet been made clear, and the nonequilibrium superconducting state of such a superconductor has not been understood till now because it depends strongly on the superconducting material.

Still further, a high-T_{c} oxide superconductor has a disadvantage that it dissolves partially by the moisture in the air, or a solution, an acidic solvent or a basic solvent to be used in the manufacturing process so as to do damage to the superconductivity and further the superconductor itself largely. Thus, the surface of the thin film of the oxide superconductor is deteriorated in an improper manufacturing process, so that the resistance value of the junction becomes anomalously large to worsen superconducting properties and to lower the yield rate of a triode. For example, an oxide superconductor which includes copper cannot use a ziazo positive-type photoresist which uses an organic alkaline solution as a developer, so that a lift-off process which makes use of a ziazo positive-type photoresist cannot be adopted in the manufacturing processes of such a superconductor. Especially, an oxide superconductor which includes yttrium is liable to get oxygen damage so that the superconducting properties become unstable by applying a metallic layer, and the secular change of its superconducting properties is also large.

### SUMMARY OF THE INVENTION

An object of the present invention is to provide a superconducting element which can control the superconducting current and has good and stable characteristics.

In order to achieve this object, in accordance with one aspect of the present invention, there is provided a superconducting element comprising a bridge made of superconducting thin film applied to a substrate, and a control electrode, which is connected to an external current source, for injection of quasi-particles into the superconducting thin film, and characterized in that at least one control electrode is provided which is made of metallic or semiconducting thin film and arranged to partially cover the superconducting thin film at the surface opposite to the substrate in a direction of the width of the bridge made of superconducting thin film, and that an end portion of said control electrode is applied to the bridge so that a narrow part of the bridge at the intersection with the control electrode is remained not to make contact with the control electrode in a direction perpendicular to the axis of the flow of the superconducting current in the bridge.

In accordance with a second aspect of the present invention there is provided a superconducting element comprising a bridge made of superconducting thin film applied to a substrate, and a control electrode, which is connected to an external current source, for injection of quasi-particles into the superconducting thin film, and characterized in that a further control electrode is provided, both control electrodes are made of metallic or semiconducting thin film, an end portion of both the control electrodes is applied to the bridge in a direction of the width of the bridge made of the superconducting thin film so that a narrow part of the bridge at the intersection with the control electrodes is remained not to make contact with the end portions of the control electrodes in a direction perpendicular to the axis of the flow of the superconducting current in the bridge, and that the two control electrodes are connected to each other by a connecting part so that the connecting part covers said narrow part of the bridge and its width measured in the direction of the flow of the superconducting current is narrower than those of the end portions of the control electrodes not connected with the connecting part.

In accordance with a third aspect of the present invention, there is provided a superconducting element comprising a bridge made of superconducting thin film applied to a substrate, and a control electrode, which is connected to an external current source, for injection of quasi-particles into the superconducting thin film, and characterized in that a further control electrode is provided, both control electrodes are made of metallic or semiconducting thin film, an end portion of both the control electrodes is applied to the bridge in a direction of the width of the superconducting thin film so that a narrow part of the bridge at the intersection between the control electrodes is remained not to make contact with the control electrodes in a direction perpendicular to the axis of the flow of the superconducting current in the bridge, and that the superconducting thin film is applied to the one control electrode formed on the substrate, and the other control electrode is applied from above to the superconducting thin film.

The material of the superconducting thin film is a metal such as niobium or lead, an alloy or a compound. The material can also be a high-T_{c} oxide superconductor such as an oxide superconductor containing copper (for example, Bi-Sr-Ca-Cu-0), Ba-Pb-Bi-0 or Ba-K-Bi-0.

Further advantageous embodiments of the superconducting element according to the present invention are defined in the subclaims 4 to 10.

Another object of the present invention is to provide a method of manufacturing such a superconducting element easily.

In order to overcome this object, in accordance with one aspect of the present invention, there is provided a manufacturing method of a superconducting element, comprising the steps of:
forming a bridge made of thin film of oxide superconductor or of both thin film of oxide superconductor and an insulating film,
applying a resin thin film having resistance to a developing solution of a photoresist to the bridge,
applying the photoresist to the resin thin film,
removing a part of the photoresist in correspondence with control electrode to be formed in a later process by the exposition and the deposition of the photoresist,
removing the exposed resin thin film by exposing it to oxygen plasma,
depositing a metallic or semiconducting thin film onto the substrate, and conducting the lift-off of the remaining resin and metallic thin films to form control electrodes.

In accordance with a further aspect of the present invention, there is provided a manufacturing method of a superconducting element, comprising the steps of:
depositing a thin film of oxide superconductor,
depositing a metallic or semiconducting thin film on the thin film of oxide superconductor in the same vacuum chamber without breaking the vacuum,
forming a bridge of the layered structure of the thin films of oxide superconductor and metal or
semiconductor by using an ion etching technique with inert gas,
forming a control electrode by the patterning of the metallic or semiconducting thin film in the bridge,
depositing a metallic or semiconducting thin film onto the substrate, and
forming an extension electrode in contact with the control electrode by the patterning.

Further advantageous embodiments of the method according to the present invention are defined in the subclaims 13 to 16.

### BRIEF DESCRIPTION OF THE DRAWINGS

Other objects and advantages of the invention will be apparent form the following description, the appending claims and the accompanying drawings in which:
Figs. 1, 3 and 5 are schematic perspective views of various embodiments of a superconducting element according to the present invention;
Figs. 2, 4 and 6 are schematic sectional views of the various embodiments of a superconducting element according to the present invention in a direction along which the superconducting current flows;
Fig. 7 is a schematic perspective view of a modified embodiment of a superconducting element according to the present invention;
Fig. 8(a) is a schematic sectional view of a superconducting element according to the present invention in a direction along which the superconducting current flows, and Fig. 8(b) and Fig. 8(c) are graphs of the superconducting order parameter ψ and the wave function ψₙ of quasiparticle when the control current I_{g} is flowed and is not flowed between the control electrodes 3a and 3b, respectively;
Figs. 9(a), 9(b), 9(c), 9(d) and 9(e) are schematic sectional views which show steps of a method of manufacturing a superconducting element according to the present invention successively;
Fig. 10 is a graph of an example of the current-voltage characteristics as a function of the control current of a superconducting element according to the present invention;
Fig. 11 is a graph of an example of the current-voltage characteristics of the superconducting element shown in Fig. 5 which is irradiated with microwaves;
Figs. 12(a), 12(b), 12(c) and 12(d) are schematic sectional and perspective views which show steps of a method of manufacturing a superconducting element according to the present invention successively; and
Figs. 13(a), 13(b), 13(c) and 13(d) are schematic sectional views which show steps of an embodiment of a process of forming extension electrodes in a method of manufacturing a superconducting element according to the present invention.

### DETAILED DESCRIPTION OF THE INVENTION

A superconducting element according to the present invention comprises, a part of the bridge is remained not to make contact with the control electrode. Thus, when quasiparticles are injected from the control electrode, the superconducting carriers in the superconducting bridge are destroyed partially so that not only the current value is controlled but also the superconducting current path is narrowed to realize a weak-coupling superconducting bridge.

Various embodiments of a superconducting element will be explained below.

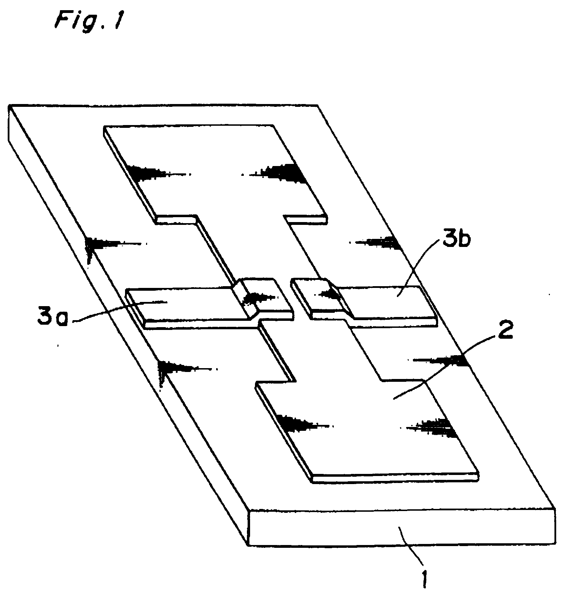

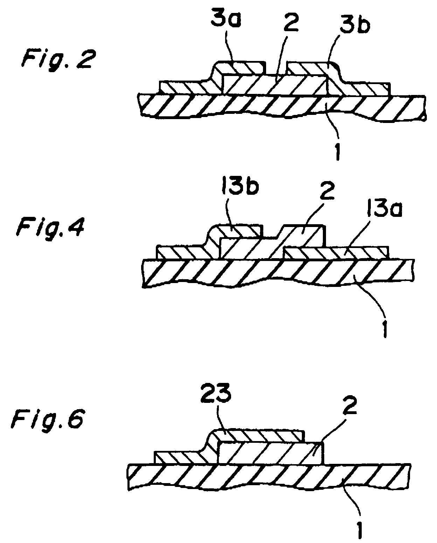

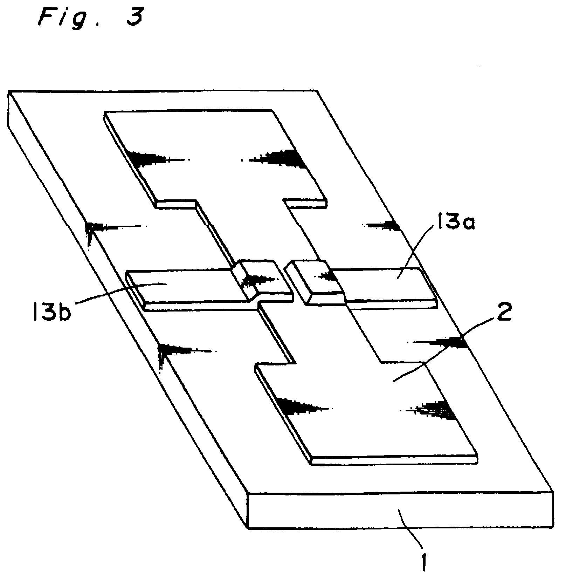

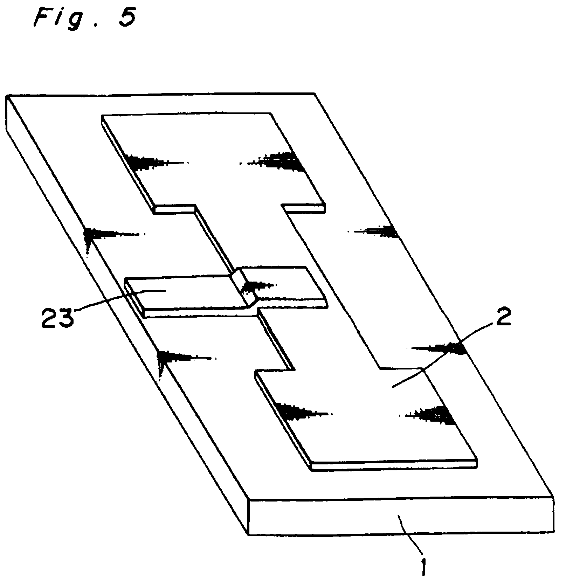

Figs. 1, 3 and 5 are schematic perspective views of embodiments of a superconducting element according to the present invention, and Figs. 2, 4 and 6 are schematic sectional views of various embodiments of the superconducting elements in a direction along which the superconducting current flows.

In a superconducting element shown in Figs. 1 and 2, a bridge of a superconducting thin film 2 is formed on a substrate 1, having two terminals at both ends for connecting the bridge to an external current supplier (not shown). Two control electrodes 3a and 3b are aligned in a direction perpendicular to the bridge of superconducting thin film 2. An end portion of each of the two control electrodes 3a, 3b is applied to the bridge, but they are separated from each other on the thin film 2. In other words, the two control electrodes 3a, 3b do not cover all the intersection with the superconducting thin film 2 in a direction perpendicular to that of the superconducting current flowing in the thin film 2.

Fig. 2 shows the crosssection of this element in a direction along the control electrodes 3a and 3b.

Insulating films may be inserted at the interface between the thin film 2 and the control electrodes 3a, 3b, if necessary.

In this element the superconducting current is flowed between the two terminals, while quasiparticles (normal current) are injected from the control electrodes 3a and 3b to the superconducting thin film 2 at the intersection in order to control the superconducting current path. The control electrode 3a and 3b are separated to each other so that quasiparticles are not injected in a part of the superconducting thin film 2 in the intersection not overlapped by the control electrodes 3a, 3b. The injected quasiparticles diffuse in the superconducting thin film 2 to destroy the superconductivity partially to form a non-equilibrium state. Thus, the superconducting current path is so narrowed in the intersection that a weak-coupling bridge is formed between the two parts of the thin film 2 separated by a boundary of the electrodes 3a, 3b.

In a modified embodiment shown in Figs. 3 and 4, a bridge of superconducting thin film 2 is applied to a control electrode 13a formed on a substrate 1, and another control electrode 13b is applied from above to the superconducting thin film 2, while there remains an area not covered by the control electrodes 13a and 13b in the intersection between the bridge 2 and the control electrodes 13a, 13b in a direction perpendicular to that of the superconducting current. Quasiparticles are injected from both control electrodes 13a, 13b into the superconducting thin film 2 in order to control the superconducting current path, whereas they are not injected into the area in the intersection not covered by the control electrodes 13a, 13b.

In a further embodiment shown in Figs. 5 and 6, a control electrode 23 is formed so as to cover the bridge of superconducting thin film except a narrow part of the surface in the intersection in a direction almost perpendicular to the direction of the superconducting current. In this case, the control current is flowed between the control electrode 23 and the superconducting thin film 2 to inject quasiparticles into the superconducting thin film 2. Quasiparticles are not injected in the narrow part not covered by the control electrode 23 in the intersection.

The two structures shown in Figs. 3 - 6 have essentially the same effect that a weak-coupling superconducting junction can be formed by the injection of quasiparticles from the control electrodes 13a, 13b, 23. Insulating films may be inserted at the interface between the superconducting thin film 2 and control electrodes 13a, 13b, 23 as in case of the superconducting element shown in Figs. 1 and 2.

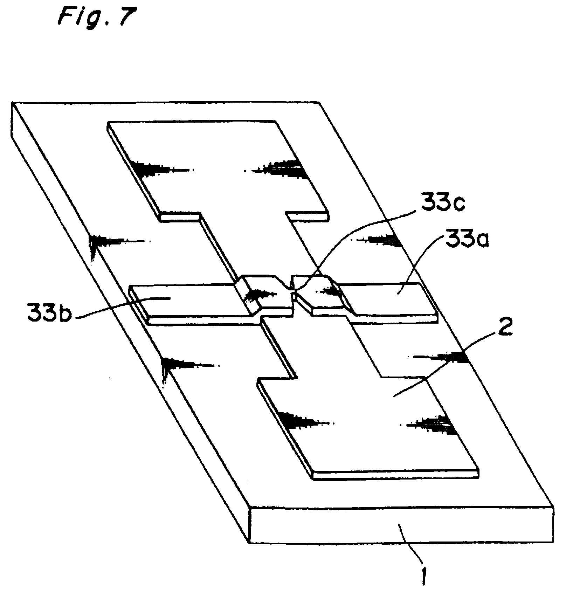

Fig. 7 shows a modified embodiment of a superconducting element according to the present invention. Two control electrodes 33a and 33b are applied to a bridge of superconducting thin film 2, and they are connected at a connecting region 33c to each other. The width of the control electrodes around the connecting region 33c measured in a direction along which the superconducting current flows becomes narrower than those of the two control electrodes 33a, 33b and has a minimum at the connecting region 33c. In this structure of the superconducting element, the density of the injected quasiparticles is continuous in a direction perpendicular to the axis of the superconducting current in the bridge, while the density becomes minimum at the connecting region 33c where the width measured in the direction of the axis of the current becomes minimum due to diffusion. Therefore, the density distribution of superconducting carriers of the bridge of superconducting thin film 2 becomes maximum at the connecting region 33c in the direction perpendicular to the axis of the current, while it becomes minimum in the direction of the axis of the current, so that a weak-coupling type superconducting bridge will be realized. If the width of the connecting region 33c is narrow sufficiently, the superconducting element has characteristics similar to those of the above-mentioned three superconducting elements.

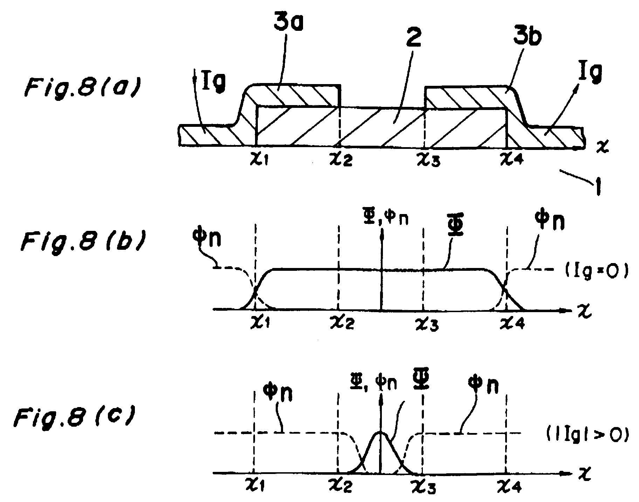

The action of the superconducting elements mentioned above will be explained with use of Figs. 8(a) - 8(c). First, we explain a superconducting element with use of a superconductor which can be explained by the Bardeen-Cooper-Schrieffer theory. Fig. 8(a) shows a section of a superconducting element schematically in a direction perpendicular to the superconducting current path, where x denotes a distance along the direction. The superconducting thin film 2 is covered by the control electrodes 3a and 3b in areas between x₁ and x₂ and between x₃ and x₄, except an area between x₂ and x₃.

Figs. 8(b) and 8(c) show the superconducting order parameter ψ and the quasiparticle wave function ψₙ when the control current I_{g} is not flowed amd it is flowed between the control electrodes 3a and 3b, respectively. In case of Fig. 8(b), the superconducting order parameter ψ extends in the superconducting thin film 2 except the boundaries at x₁ and at x₄ of the interfaces between the ends of superconducting thin film 2 and the control electrodes 3a, 3b.

It is found that the superconducting current flows in the superconducting thin film almost homogeneously because |ψ| corresponds to the carrier density of the superconducting current. On the other hand, in case of Fig. 8(c) wherein the control current I_{g} is flowed, quasiparticles which consist of electrons and holes are injected into the superconducting state is partially destroyed to create nonequilibrium superconducting regions. In other words, the quasiparticle wave function ψₙ extends into the regions of x₁ < x < x₂ and of x₃ < x < x₄, while the superconducting order parameter ψ is restricted in a region between x₂ and x₃.

As an amount of the injected quasiparticles increases, the extension of the superconducting order parameter ψ becomes narrower. The width of the superconducting current path can be narrowed to form a weak-coupling bridge by increasing the control current because it becomes of the order of the superconducting order parameter |ψ|.

This is an important action of the superconducting elements explained above. As to the high-T_{c} oxide superconductor, the above-mentioned action due to the nonequilibrium superconducting phenomena has not yet been made clear. However, some experiments on superconducting elements with use of high-T_{c} oxide superconductor by the inventors show that the characteristics of such elements can also be explained by the above-mentioned action.

In structures wherein insulators are inserted between the superconducting thin film 2 and the control electrodes 3a, 3b, 13a, 13b, 23, the tunnel junction thus formed can make the applied voltage between them higher so that more effective control becomes possible by increasing the quasi-particle energy of the injecting control current.

On the other hand, when a high-T_{c} oxide superconductor is used for the material of the superconducting thin film 2 and a metal including at least aluminum is used for the material of the control electrode 3a, 3b, 13a, 13b, 23 or it is applied at the side to make contact with the high-T_{c} oxide superconductor, characteristics are found to be similar to those of the above-mentioned structures with the inserted insulator films. This is ascribable to the aluminum atoms which are likely to get oxygen atoms from the high-T_{c} oxide superconductor to form an insulating oxide at the interface between them.

As explained above, a superconducting element according to the embodiments can control the superconducting current value fast by the current injected by the control electrodes. Further, this superconducting element can be used as a modulation element with a current signal input, and it can act as a bi-directional amplification element or a switching element similarly to a transistor. Further, it can act as a weak-coupling Josephson element which can change the critical current by controlling the control current. Thus, it can be used for a superconducting quantum interference detector whose characteristics can be controlled. Still further, it can be used for a detector or a mixer of microwaves, milliwaves, far infrared rays or infrared rays whose characteristics can be controlled.

Thus, a superconductor according to the present invention has a large practical advantage in the area of components, electronic instruments and metering devices.

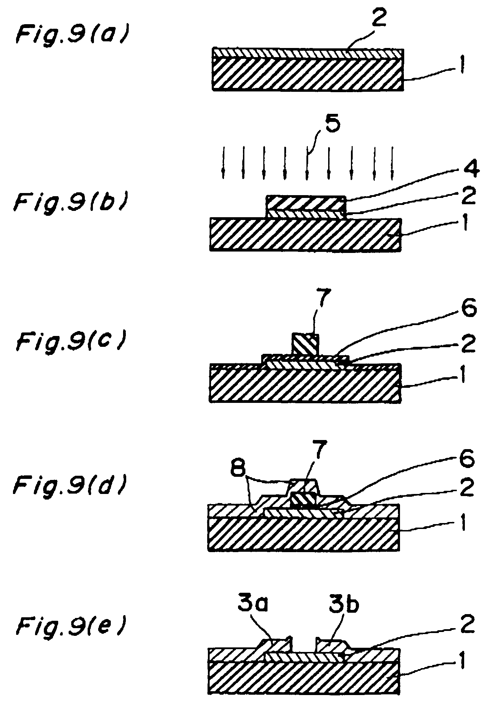

An embodiment of a method of manufacturing a superconducting element mentioned above will be explained below with reference to Figs. 9(a) - 9(e).

As shown in Fig. 9(a), a superconducting thin film 2 of thickness 200 nm of Bi-Sr-Ca-Cu-O oxide superconductor is formed on a (100) face of MgO single crystal as a substrate 1 by using rf planer magnetron sputtering process and by heating it at 670 °C in argon-O₂ environment at 0.667 Pa (5mTorr). Then, the thin film 2 is subjected to heat treatment at 845 °C for ten hours in an O₂ environment at one atomospheric pressure. The superconducting transition temperature T_{c} of the thin film 2 is 86 K.

Then, as shown in Fig. 9(b), the superconducting thin film 2 is patterned by using a negative-type photoresist 4 and is etched by ion milling with use of argon ions 5. The remaining photoresist 4 is removed next. Thus, a bridge of superconducting film 2 is formed on the substrate 1, and the width of the superconducting film 2 which will overlap the control electrodes is about 10 µm.

Next, as shown in Fig. 9(c), a negative type photoresist of thickness 70 nm is applied to the superconducting thin film 2 and the substrate 1 as a resin thin film 6 which has resistance to organic alkaline solution. Further, a positive-type photoresist 7 of thickness 800 nm is applied to the resin thin film 6. Then, some regions of positive-type photoresist 7 in correspondence with the control electrodes 3a, 3b is removed so that the width of the control electrodes 3a, 3b is set to be about 5 µm and the gap between them is set to be aout 2 µm, and both control electrodes are designed to be almost perpendicular to the superconducting thin film 2. Though an organic alkaline solution is used as a developing solution for the positive-type photoresist, it does not make contact with the thin film 2 of a high-T_{c} oxide superconductor which has been covered by the resin thin film 6, so that the superconducting properties are not deteriorated.

Then, as shown in Fig. 9(d), after the exposed resin thin film 6 is removed by subjecting it to oxygen plasma, aluminum of thickness 100 nm is deposited in vacuum as a metallic thin film 8.

Next, as shown in Fig. 9(e), the photoresist 7 is removed by a lift-off by immersing it in acetone, and the resin thin film 6 is removed by immersing it in 1, 1, 1-trichloroethane, to form metallic control electrodes 3a, 3b. The distance between the control electrodes 3a and 3b is about 2 µm. Thus, the manufacturing process of a superconducting element completes.

A superconducting element manufactured as mentioned above has an insulator of aluminum oxide formed at the interface between the control electrodes 3a, 3b and the superconducting thin film 2 of oxide superconductor, so that a tunnel junction is formed between the control electrodes 3a, 3b and the superconducting thin film 2. Further, when a different metal which is liable to be oxidized other than aluminum is used for the control electrodes 3a, 3b, an insulator is also formed at the interface.

On the other hand, when a noble metal such as platinum or gold is used for the material of the control electrodes, an insulator is not formed at the interface and the resistance between the control electrodes 3a, 3b and the superconducting thin film 2 is low. In this case, if an insulating film of MgO or others of thickness about 10 nm is formed between the superconducting thin film 2 and the control electrodes 3a, 3b, a superconducting element is obtained having characteristics similar to the above-mentioned one containing aluminum.

Characteristics of the above-mentioned superconducting elements are similar to each other irrespective of the existence of an insulator at the interface.

In a case that an insulator film is formed for protection on a superconducting thin film of oxide superconductor, the insulator film cannot be made thick. Thus, a solution is lible to penetrate through pin holes in the insulator film to deteriorate the superconducting thin film. On the contrary, the manufacturing method according to the present invention can prevent the deterioration of the thin film of oxide superconductor. In other words, a resin thin film which has resistance to the developing solution of photoresist can prevent the direct contact of the superconducting thin film with the developing solution, so that the superconducting properties of oxide superconductor are not deteriorated. Thus, a superconducting element which can be operated at liquid nitrogen temperatures can be manufactured. Furthermore, because the process of forming the superconducting thin film is independent of the process of forming the control electrodes, the optimum conditions can be adopted for each of the two processes, so that the characteristics can be improved and the yield rate can be increased. Still further, a process such as post-anneal can be incorporated in the process for forming the superconducting thin film of high-T_{c} oxide superconductor.

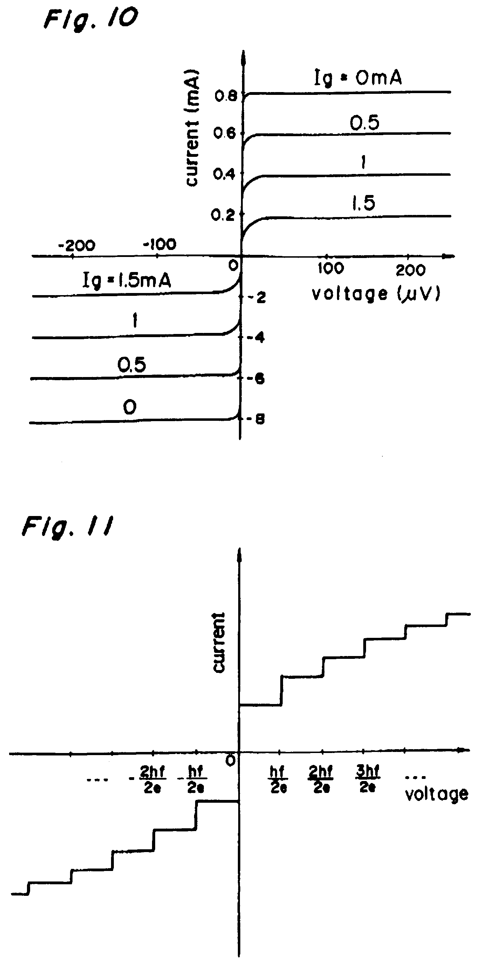

The characteristics of a superconducting element manufactured as mentioned above will be explained below. The superconducting element was kept at 77.3 K in liquid nitrogen. The observed current-voltage characteristics showed that the superconducting critical current flowing the superconducting thin film 2 was 0.78 mA. When a current from 0 to 1.5 mA is injected from the control electrodes 3a, 3b, the superconducting critical current value varied from 0.78 mA to 80 µA. Fig. 10 shows an example of the current-voltage characteristics as a function of control current I_{g}. This change was continuous and reversible against the injection current of the control electrodes 3a, 3b.

Next, microwaves at 10 GHz were irradiated to the superconducting element kept in the above-mentioned conditions. The AC Josephson effect was not observed when the control current I_{g} was small. On the other hand, as shown in Fig. 11, when the control current I_{g} is 1.2 mA or more, a current step (Shapiro step) was observed at electrical voltages of an integral number times hf/2e = 2.068 × f (µV) (wherein h is Planck's constant 6.626 × 10⁻³⁴ J·S, e is the elementary charge 1.602 × 10⁻¹⁹ C, and f is frequency expressed in the unit of GHz), or the AC Josephson effect was confirmed. This shows that a weak-coupling bridge was realized when the control current I_{g} is 1.2 mA or more.

As to a superconducting element having control electrodes of the structure shown in Fig. 7, the control characteristics similar to those shown in Fig. 10 and the AC Josephson characteristics similar to those shown in Fig. 11 were observed.

As explained above, it was found that the superconducting current can be controlled fast by the injection of the control current and that a weak-coupling bridge can be realized by controlling the control current value.

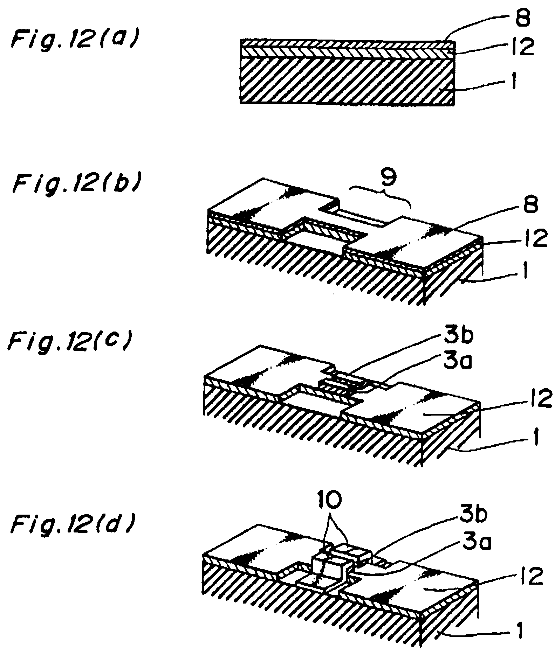

Next, a second embodiment of a method of manufacturing a superconducting element will be explained below, with reference to Figs. 12(a) - 12(b).

First, as shown in Fig. 12(a), a superconducting thin film 12 of high-T_{c} oxide superconductor of for example an oxide superconductor containing copper such as Bi-Sr-Ca-Cu-O of thickness about 200 nm is deposited on a (001) face of MgO single crystal as a substrate 1 by using for example an rf magnetron sputtering process at the temperature of the substrate 1 of about 670 °C in the argon-oxygen environment. Then, after the substrate 1 is cooled down to about room temperature, aluminum is deposited up to a thickness about 100 µm without breaking the vacuum by using an rf magnetron sputtering process, and gold is deposited further up to a thickness 50 nm. Thus, a metallic thin film 8 is applied to the superconducting thin film 12. The gold is used to prevent the oxidation or the surface or the metallic thin film 8 on the following process for removing photoresist by oxygen plasma, but it is not necessarily needed basically. It is effective to deposite an insulator thin film such as MgO on the superconducting thin film of oxide superconductor before applying the metallic thin film 8.

Next, as shown in Fig. 12(b), the substrate 1 is taken out from the vacuum chamber, and the thin film 12 of oxide superconductor and the metallic thin film 8 are formed both to have a width about 10 µm in the surface direction and a length about 20 µm to form a bridge 9 by using a photolithography process with cyclized rubber negative-type photoresist and an ion-etching process with argon gas. The gas pressure is about 133.322 × 10⁻¹⁴ Pa (1 × 10⁻¹⁴ Torr) and the ion acceleration voltage is about 550 V.

Then, after removing the photoresist by oxygen plasma, as shown in Fig. 12(c), control electrodes 3a and 3b are formed by removing partially the metallic thin film 8 on the bridge 9, by using a similar process of forming the bridge 9. The Fig. 12(c) shows a case of separate control electrodes of Figs. 1 and 2. The width of the control electrodes is about 10 µm, while the gap between the control electrodes on the superconducting thin film 12 is about 2 µm.

The order of the process of forming a bridge shown in Fig. 12(b) and that of forming control electrodes shown in Fig. 12(c) can be reversed.

Next, aluminum of thickness about 200 nm is deposited on the surface of the exposed control electrodes 3a, 3b by using an rf magnetron sputtering process, and only the unnecessary area is removed by using an ion etching technique to form extension electrodes 10, as shown in Fig. 12(d), which are connected electrically to the control electrodes 3a, 3b. Thus, a superconducting element is completed.

Another process of forming the extension electrodes is possible by using lift-off. That is, a lift-off mask for extension electrodes to be applied on a part of the control electrodes exposed for contact is formed by using photolithography with photoresist such as PMMA electronic beam photoresist which uses a olephilic organic solvent such as ketone as a developing solution. Then, a thin film for the extension electrodes is deposited by using the lift-off mask. Then, lift-off is conducted by immersing the substrate in acetone or the like.

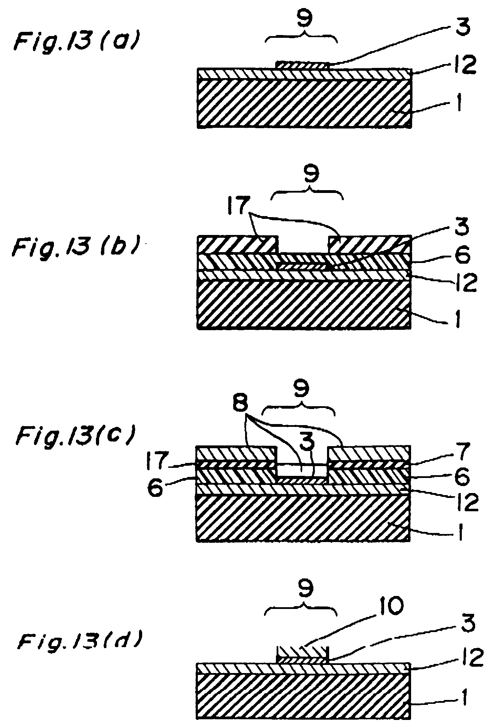

A still different process of forming the extension electrodes will be explained with reference to Figs. 13(a) - 13(d).

First, as shown in Fig. 13(a), control electrode 3 is formed on the thin film 12 of oxide superconductor of the bridge 9.

Then, as shown in Fig. 13(b), a resin thin film 6 which has resistance against a developing solution of photoresist 17 for patterning, such as cresolnovolak naphthoquinonediazide positive-type photoresist, is coated on the substrate with spinning up to thickness 700 nm, and then a photoresist for patterning is coated on the resin thin film 6 with spinning up to thickness 1 µm. Next, the photoresist 17 is exposed and deposited. The resin thin film 6 does not dissolve in this process because the developing solution used is xylene.

Next, as shown in Fig. 13(c), a part of the positive-type photoresist (resin thin film 6) in correspondence to the extension electrodes is removed by using the exposition of the substrate of oxygen plasma or by using argon ion trimming to expose a part of the control electrodes.

Then, as shown in Fig. 13(d), the substrate is immersed in an organic solvent such as acetone so that at least one of the resin thin film 6 and the photoresist (resin thin film in this case) is lifted off by swelling and dissolution to form extension electrodes 10.

It is difficult to estimate precisely the deterioration of the thin film 12 of high-T_{c} oxide superconductor in the manufacturing processes of superconducting element because the metallic thin film 8 is layered. However, the deterioration of characteristics can be guessed from the comparison with those of a thin film of oxide superconductor without being applied to the metallic thin film 8. This shows that the transition temperature and the critical current density are of the same order in both cases. Therefore, we consider that the deterioration of the characteristics is suppressed to a minimum extent on the manufacturing process of a superconducting element.

Further, the current-voltage characteristics between one of the control electrodes 3 and the thin film 12 of oxide superconductor of a superconducting element manufactured as mentioned above shows that a good tunnel barrier without hysteresis, fluctuations and drift. Moreover, when a current is flowed between the control electrode 3 and the superconducting thin film 12. The superconducting current which flows in the superconducting thin film 12 can be suppressed, and the ratio of the suppression of the superconducting current against the control current is as high as about ten. That is, it is found that a good element characteristics can be obtained.

A superconducting element manufactured according to a second method mentioned above has better characteristics and is more stable generally when compared with that manufactured according to a first method mentioned above. As to the yield rate, the former is also better than the latter.

The material of the substrate 1 used in the above-mentioned embodiments is MgO, and the material of the superconducting thin film 2, 12 used in the above-mentioned embodiments is for example Bi-Sr-Ca-Cu-O high-T_{c} oxide superconductor. However, superconducting thin films of other oxide superconductor containing copper, Ba-Pb-Bi-O or Ba-K-Bi-O has similar effects to Bi-Sr-Ca-Cu-O. Thus the substrate can be selected according to the superconducting material. Further, as to the material for the superconducting thin film, metal containing niobium or lead, alloy or metallic compound can also be used effectively.

Further, the deposition of the superconducting thin film of oxide superconductor can be conducted by using reactive vacuum deposition process, laser deposition process or the like as well as the rf magnetron sputtering process.

Moreover, aluminum film or a double layer film of aluminum and gold can be used for the metallic thin film 8 in the above-mentioned embodiments. However, a similar advantage is observed for a metallic thin film 8 made of other materials such as an alloy material containing aluminum or a layered structure of a metal film containing aluminum deposited on the side of the thin film 12 of oxide superconductor and another metallic film of metallic material of gold, silver, platinum or the like or of alloy material on the other side. Still further, a semiconductor thin film made of silicon or the like can also be used instead of the metallic thin film.

A deposition process other than the rf magnetron sputtering process can be used as far as it is conducted without breaking the vacuum in the same vacuum chamber and it is compatible with the process of forming a superconducting thin film. For example, other vacuum deposition processes, an electronic deposition process, an ion beam deposition process or a laser deposition process can be adopted.

The material of the extension electrodes 10 is aluminum in the embodiments. However, any other metal, alloy, semiconductor or superconductor which can have an ohmic contact with the control electrodes 3 can be used for the extension electrodes 10.

Further, a negative-type photoresist is used in the above-mentioned embodiment for the resin thin film 6 which has resistance to an organic alkaline solution. However, any other resin thin films having resistance to a developing solution of the photoresist of the layer applied above can be used such as polyimide resin, rubber resin, or PMMA resin.

As explained above, in a second manufacturing method of a superconducting element, a good interface can be formed between the superconducting thin film and the metallic or semiconducting thin film because both are deposited in the same vacuum chamber successively without breaking the vacuum. The interface is kept good, not contaminated in the following processes. Thus, a superconducting element of good characteristics can be manufactured at a high yield rate.

Further, it is found that a good and stable tunnel barrier can be formed naturally between the metallic thin film 8 and the superconducting thin film 12 of oxide superconductor when a metallic material containing at least aluminum is deposited without breaking the vacuum as the metallic thin film or at least at the side of layered structure metallic films in contact with the superconducting thin film because the aluminum takes oxygen in the oxide superconductor to form an aluminum oxide film.

Though a part of the surface of the thin film of the oxide superconductor is etched in the process of forming a bridge and control electrodes with use of ion etching technique with inert gas, the deterioration of the characteristics of the superconducting thin film of oxide superconductor can be suppressed to a minimum degree because the etching gas ions are inert.

Further, the tunnel barrier formed naturally at the interface between the thin film of oxide superconductor and the control electrodes is not disturbed and is kept in a good state in the following processes of the manufacturing method because the metallic thin film which will become the control electrodes plays a role of protection film in the air and in the photolithography process and the processes after the formation of the control electrodes do not use heat treatment at high temperature.

If the superconducting thin film is made of oxide superconductors such as those containing copper such as Bi-Sr-Ca-Cu-O or Y-Ba-Cu-O, or Ba-Pb-Bi-O or Ba-K-Bi-O, the superconducting element can be operated at higher temperatures when compared with a superconducting element with a superconducting thin film made of a low-T_{c} superconductor such as niobium.

The extension electrodes are formed after the control electrodes are formed, so that both are connected electrically through an ohmic junction such as metal-metal junction or metal-natural oxide-metal junction. Therefore, the process of forming a tunnel barrier of the control electrodes can be separated from the metallization process, and the conditions of the processes can be optimized easily.

In the process of forming extension electrodes, a thin film deposited for forming extension electrodes or a resin thin film having resistance to a developing solution of photoresist plays a role of protection film in the photoprocess, that is, it prevents the exposed surface of the superconducting thin film of oxide superconductor from making contact with water, acidic or basic aqueous solution or organic solvent. Thus, the deterioration of the characteristics of the thin film of oxide superconductor can be suppressed to a minimum degree. Moreover, if a photoresist which uses a olephilic organic solvent, the exposed thin film of oxide superconductor does not dissolve in the developing solution after the deposition. Thus, the derioration of the characteristics of the thin film can also be suppressed to a minimum degree.

In conclusion, a superconducting element having stable and good characteristics can be manufactured reproducibly, and the yield rate can be improved so as to lower the cost. Further, a superconducting element having a high efficiency and stable characteristics can be manufactured because the interface between the control electrodes and the thin film of oxide superconductor is kept clean and the ratio of the appearance of interface levels is small due to the continuous formation of both layers in the vacuum chamber without breaking the vacuum.

## Claims

1. A superconducting element, comprising:
a bridge made of superconducting thin film (2) applied to a substrate (1), and
a control electrode (3a, 3b; 13a, 13b; 23), which is connected to an external current source, for injection of quasi-particles into the superconducting thin film (2),
characterized in that
at least one control electrode (3a, 3b; 13a, 13b; 23) is provided which is made of metallic or semiconducting thin film and arranged to partially cover the superconducting thin film (2) at the surface opposite to the substrate (1) in a direction of the width of the bridge made of superconducting thin film (2), and that
an end portion of said control electrode (3a, 3b; 13a, 13b; 23) is applied to the bridge so that a narrow part of the bridge at the intersection with the control electrode (3a, 3b; 13a, 13b; 23) is remained not to make contact with the control electrode (3a, 3b, 13a, 13b; 23) in a direction perpendicular to the axis of the flow of the superconducting current in the bridge.

2. A superconducting element, comprising:
a bridge made of superconducting thin film (2) applied to a substrate (1), and
a control electrode (33a), which is connected to an external current source, for injection of quasi-particles into the superconducting thin film (2),
characterized in that
a further control electrode (33b) is provided,
both control electrodes (33a, 33b) are made of metallic or semiconducting thin film,
an end portion of both the control electrodes (33a, 33b) is applied to the bridge in a direction of the width of the bridge made of the superconducting thin film (2) so that a narrow part of the bridge at the intersection with the control electrodes (33a, 33b) is remained not to make contact with the end portions of the control electrodes (33a, 33b) in a direction perpendicular to the axis of the flow of the superconducting current in the bridge, and that
the two control electrodes (33a, 33b) are connected to each other by a connecting part (33c) so that the connecting part (33c) covers said narrow part of the bridge and its width measured in the direction of the flow of the superconducting current is narrower than those of the end portions of the control electrodes (33a, 33b) not connected with the connecting part (33c).

3. A superconducting element, comprising:
a bridge made of superconducting thin film (2) applied to a substrate (1), and
a control electrode (13a), which is connected to an external current source, for injection of quasi-particles into the superconducting thin film (2),
characterized in that
a further control electrode (13b) is provided,
both control electrodes (13a, 13b) are made of metallic or semiconducting thin film,
an end portion of both the control electrodes (13a, 13b) is applied to the bridge in a direction of the width of the superconducting thin film (2) so that a narrow part of the bridge at the intersection between the control electrodes (13a, 13b) is remained not to make contact with the control electrodes (13a, 13b) in a direction perpendicular to the axis of the flow of the superconducting current in the bridge, and that
the superconducting thin film (2) is applied to the one control electrode (13a) formed on the substrate (1), and the other control electrode (13b) is applied from above to the superconducting thin film (2).

4. A superconducting element according to claim 1, 2 or 3, further comprising an insulating thin film applied between the bridge and the control electrode.

5. A superconducting element according to one of claims 1 to 4, wherein said superconducting thin film (2) is made of a metal such as niobium or lead, an alloy or a metallic compound.

6. A superconducting element according to one of claims 1 to 5, wherein said superconducting thin film (2) is made of a high-T_{c} oxide superconductor.

7. A superconducting element according to claim 6, wherein said high-T_{c} oxide superconductor include copper atoms.

8. A superconducting element according to claim 7, wherein said high-T_{c} oxide superconductor is a Bi-Sr-CaCu-0 oxide superconductor.

9. A superconducting element according to claim 6, wherein said high-T_{c} oxide superconductor is Ba-Pb-Bi0 or Ba-K-Bi-0 oxide superconductor.

10. A superconducting element according to claim 6, wherein said metallic film or at least a part of said metallic film to make contact with the high-T_{c} oxide superconductor is made of a metal containing at least aluminum.

11. A manufacturing method of a superconducting element according to one of claims 1 to 3, comprising the steps of:
forming a bridge made of thin film (2) of oxide superconductor or of both thin film (2) of oxide superconductor and an insulating film,
applying a resin thin film having resistance to a developing solution of a photoresist (4) to the bridge,
applying the photoresist (4) to the resin thin film,
removing a part of the photoresist (4) in correspondence with control electrode (3a, 3b, 13a, 13b, 23, 33a, 33b) to be formed in a later process by the exposition and the deposition of the photoresist (4),
removing the exposed resin thin film by exposing it to oxygen plasma,
depositing a metallic or semiconducting thin film (8) onto the substrate (1), and conducting the lift-off of the remaining resin (6) and metallic thin films (8) to form control electrodes.

12. A manufacturing method of a superconducting element according to one of claims 1 to 3, comprising the steps of:
depositing a thin film (12) of oxide superconductor,
depositing a metallic or semiconducting thin film (8) on the thin film of oxide superconductor (12) in the same vacuum chamber without breaking the vacuum,
forming a bridge (9) of the layered structure of the thin films of oxide superconductor (12) and metal or
semiconductor (8) by using an ion etching technique with inert gas, forming a control electrode (3a, 3b, 13a, 13b, 23, 33a, 33b) by the patterning of the metallic or semiconducting thin film (8) in the bridge,
depositing a metallic or semiconducting thin film (8) onto the substrate, and
forming an extension electrode (10) in contact with the control electrode (3a, 3b, 13a, 13b, 23, 33a, 33b) by the patterning.

13. A manufacturing method according to claim 12, further comprising a step of depositing an insulating thin film after the step of depositing the thin film of oxide superconductor (12) before the step of depositing the thin film (8) of metallic or semiconducting thin film.

14. A manufacturing method according to claim 12, wherein said step of forming an extension electrode (10) comprises the steps of:
depositing a metallic thin film, and
removing the metallic thin film except the part
for extension electrodes by using an ion etching technique with inert gas.

15. A manufacturing method according to claim 12, wherein said step of forming an extension electrode (10) comprises the steps of:
forming a lift-off mask for forming the extension electrode (10) by using a photolithography technique with a photoresist which uses a olephilic organic solvent as a developing solution,
depositing a thin film (12) for extension electrode
applied to the exposed surface of control electrode, and conducting the lift-off of the remaining photoresist to form a control electrode (10).

16. A manufacturing method according to claim 12,
wherein said step of forming an extension electrode (10) comprises the steps of:
depositing a resin thin film (6), having resistance to a developing solution of a photoresist (17) to be applied later, on the superconducting thin film (2) and the control electrode (3a, 3b, 13a, 13b, 23, 33a, 33b),
applying the photoresist (17) to the resin thin film (6), removing the resin thin film (6) by the exposition and deposition except a part in correspondence with an extension electrode (10),
exposing the part of the resin thin film (6) to oxygen plasma, depositing a thin film (8) for extension electrode (10) onto the substrate, and
conducting the lift-off of the remaining photoresist to form the extension electrode (10).

## Patentansprüche

1. Supraleitendes Element, mit:
einer Brücke aus supraleitendem Dünnfilm (2), welcher auf ein Substrat (1) aufgetragen ist, und
einer steuerungselektrode (3a, 3b; 13a, 13b; 23), welche an eine externe Stromquelle angeschlossen ist, zum Injizieren von Quasipartikeln in den supraleitenden Dünnfilm (2),
dadurch gekennzeichnet, daß
wenigstens eine Steuerungselektrode (3a, 3b; 13a, 13b; 23) vorgesehen ist, welche aus einem metallischen oder halbleitenden Dünnfilm hergestellt und so angeordnet ist, daß sie den supraleitenden Dünnfilm (2) an der Oberfläche gegenüber dem Substrat (1) in Richtung der Breite der aus supraleitendem Dünnfilm (2) hergestellten Brücke teilweise bedeckt, und daß
ein Endabschnitt der Steuerungselektrode (3a, 3b; 13a, 13b; 23) auf die Brücke aufgetragen ist, so daß ein schmaler Teil der Brücke an der Zwischensektion mit der Steuerungselektrode (3a, 3b; 13a, 13b; 23) verbleibt, der keinen Kontakt mit der Steuerungselektrode (3a, 3b; 13a, 13b; 23) in einer Richtung senkrecht zu der Achse des Flusses des Supraleitungsstromes in der Brücke aufweist.

2. Supraleitendes Element, mit:
einer Brücke aus einem auf ein Substrat (1) aufgetragenen supraleitenden Dünnfilm (2), und
einer Steuerungselektrode (33a), welche an eine externe Stromquelle angeschlossen ist, zum Injizieren von Quasipartikeln in den supraleitenden Dünnfilm (2), dadurch gekennzeichnet, daß
eine weitere Steuerungselektrode (33b) vorgesehen ist,
beide Steuerungselektroden (33a, 33b) aus metallischem oder halbleitendem Dünnfilm hergestellt sind,
ein Endabschnitt beider Steuerungselektroden (33a, 33b) in Richtung der Breite der aus dem supraleitenden Dünnfilm (2) hergestellten Brücke auf die Brücke aufgetragen ist, so daß ein schmaler Teil der Brücke an der Zwischensektion mit den Steuerungselektroden (33a, 33b) außer Kontakt mit den Endabschnitten der Steuerungselektroden (33a, 33b) in einer Richtung senkrecht zu der Achse des Flusses des supraleitenden Stromes in der Brücke bleibt, und daß
die zwei Steuerungselektroden (33a, 33b) durch ein Verbindungsteil (33c) miteinander verbunden sind, so daß das Verbindungsteil (33c) den schmalen Teil der Brücke bedeckt und seine in der Richtung des Flusses des Supraleitungsstromes gemessene Breite geringer ist als diejenige der Endabschnitte der Steuerungselektroden (33a, 33b), die nicht mit dem Verbindungsteil (33c) verbunden sind.

3. Supraleitendes Element, mit:
einer auf einem Substrat (1) aufgetragenen Brücke aus einem supraleitenden Dünnfilm (2), und
einer Steuerungselektrode (13a), welche an eine externe Stromquelle angeschlossen ist, zum Injizieren von Quasipartikeln in den supraleitenden Dünnfilm (2), dadurch gekennzeichnet, daß
eine weitere Steuerungselektrode (13b) vorgesehen ist,
beide Steuerungselektroden (13a, 13b) aus einem metallischen oder halbleitenden Dünnfilm hergestellt sind,
ein Endabschnitt beider Steuerungselektroden (13a, 13b) auf die Brücke in Richtung der Breite des supraleitenden Dünnfilmes (2) aufgetragen ist, so daß ein schmaler Teil der Brücke an der Zwischensektion zwischen den Steuerungselektroden (13a, 13b) ohne Kontakt mit den Steuerungselektroden (13a, 13b) in einer Richtung senkrecht zu der Achse des Flusses des Supraleitungsstromes in der Brücke bleibt, und daß
der supraleitende Dünnfilm (2) auf die eine auf dem Substrat (1) ausgebildete Steuerungselektrode (13a) und die andere Steuerungselektrode (13b) von oben auf den supraleitenden Dünnfilm (2) aufgebracht ist.

4. Supraleitendes Element nach Anspruch 1, 2 oder 3, welches weiterhin einen isolierenden Dünnfilm umfaßt, der zwischen der Brücke und der Steuerungselektrode aufgetragen ist.

5. Supraleitendes Element nach einem der Ansprüche 1 bis 4, bei welchem der supraleitende Dünnfilm (2) aus einem Metall wie Niob oder Blei, einer Legierung oder einer metallischen Zusammensetzung hergestellt ist.

6. Supraleitendes Element nach einem der Ansprüche 1 bis 5, bei welchem der supraleitende Dünnfilm (2) aus einem Hoch-T_{c}-Oxid-Supraleiter hergestellt ist.

7. Supraleitendes Element nach Anspruch 6, bei welchem der Hoch-T_{c}-Oxid-Supraleiter Kupferatome beinhaltet.

8. Supraleitendes Element nach Anspruch 7, bei welchem der Hoch-T_{c}-Oxid-Supraleiter ein Bi-Sr-Ca-Cu-O-Oxid-Supraleiter ist.

9. Supraleitendes Element nach Anspruch 6, bei welchem der Hoch-T_{c}-Oxid-Supraleiter ein Ba-Pb-Bi-O- oder Ba-K-Bi-O-Oxid-Supraleiter ist.

10. Supraleitendes Element nach Anspruch 6, bei welchem der metallische Film oder wenigstens ein Teil des metallischen Films zum Herstellen des Kontaktes mit dem Hoch-T_{c}-Oxid-Supraleiter aus einem Metall besteht, das mindestens Aluminium enthält.

11. Herstellungsverfahren für ein supraleitendes Element gemäß einem der Ansprüche 1 bis 3, mit den Schritten:
Ausbilden einer Brücke aus einem Dünnfilm (2) eines Oxid-Supraleiters oder aus dem Dünnfilm (2) eines Oxid-Supraleiters und einem Isolationsfilm, Auftragen eines Harz-Dünnfilmes, der gegen eine Entwicklerlösung eines Fotolacks (4) resistent ist, auf die Brücke,
Auftragen des Fotolacks (4) auf den Harz-Dünnfilm,
Entfernen eines Teiles des Fotolacks (4) entsprechend der Steuerungselektrode (3a, 3b, 13a, 13b, 23, 33a, 33b), die in einem späteren Prozeß durch das Freilegen und das Ablagern des Fotolackes (4) auszubilden ist,
Entfernen des freigelegten Harz-Dünnfilmes, indem er einem Sauerstoffplasma ausgesetzt wird,
Ablagern eines metallischen oder halbleitenden Dünnfilmes (8) auf dem Substrat (1) und Ausführen des Abtragens des verbleibenden Harzes (6) und des metallischen Dünnfilmes (8) zum Ausbilden von Steuerungselektroden.

12. Herstellungsverfahren eines supraleitenden Elementes gemäß einem der Ansprüche 1 bis 3, mit den Schritten:
Ablagern eines Dünnfilmes (12) eines Oxid-Supraleiters,
Ablagern eines metallischen oder halbleitenden Dünnfilmes (8) auf dem Dünnfilm aus Oxid-Supraleiter (12) in der gleichen Vakuumkammer ohne Aufheben des Vakuums,
Ausbilden einer Brücke (9) der geschichteten Anordnung der Dünnfilme des Oxid-Supraleiters (12) und des Metalls oder Halbleiters (8) durch Verwenden einer lonenätztechnik mit Inertgas,
Ausbilden einer Steuerungselektrode (3a, 3b, 13a, 13b, 23, 33a, 33b) durch Modellieren des metallischen oder halbleitenden Dünnfilmes (8) der Brücke,
Ablagern eines metallischen oder halbleitenden Dünnfilmes (8) auf dem Substrat, und
Ausbilden einer Erweiterungselektrode (10) in Kontakt mit der Steuerungselektrode (3a, 3b, 13a, 13b, 23, 33a, 33b) durch Modellieren.

13. Herstellungsverfahren nach Anspruch 12, welches weiterhin einen Schritt des Ablagerns eines isolierenden Dünnfilms nach dem Schritt des Ablagerns des Dünnfilms des Oxid-Supraleiters (12) und vor dem Schritt des Ablagerns des Dünnfilms (8) aus metallischem oder halbleitenden Dünnfilm umfaßt.

14. Herstellungsverfahren nach Anspruch 12, bei welchem der Schritt des Ausbildens einer Erweiterungselektrode (10) die Schritte umfaßt:
Ablagern eines metallischen Dünnfilmes und
Entfernen des metallischen Dünnfilmes mit Ausnahme des Teiles für die Erweiterungselektrode durch Verwenden einer lonenätztechnik mit Inertgas.

15. Herstellungsverfahren nach Anspruch 12, bei welchem der Schritt des Ausbildens einer Erweiterungselektrode (10) die Schritte umfaßt:
Ausbilden einer Abhebemaske zum Ausbilden der Erweiterungselektrode (10) durch Verwenden einer Fotolithographietechnik mit einem Fotolack, welcher ein oleophiles, organisches Lösungsmittel als Entwicklerlösung verwendet,
Ablagern eines Dünnfilms (12) für die auf die freigelegte Oberfläche der Steuerungselektrode aufgebrachte Erweiterungselektrode und Ausführen des Abhebens des verbleibenden Fotolacks zum Ausbilden einer Steuerungselektrode (10).

16. Herstellungsverfahren nach Anspruch 12, bei welchem der Schritt des Ausbildens einer Erweiterungselektrode (10) die Schritte umfaßt:
Ablagern eines Harz-Dünnfilmes (6), der gegen eine Entwicklerlösung eines später aufzutragenen Fotolacks (17) resistent ist, auf den supraleitenden Dünnfilm (2) und die Steuerungselektrode (3a, 3b, 13a, 13b, 23, 33a, 33b),
Auftragen des Fotolacks (17) auf den Harz-Dünnfilm (6), Entfernen des Harz-Dünnfilms (6) durch Freilegen und Ablagern mit Ausnahme eines einer Erweiterungselektrode (10) entsprechenden Teiles,
Aussetzen des Teils des Harz-Dünnfilmes (6) in einem Sauerstoffplasma,
Ablagern eines Dünnfilmes (8) für die Erweiterungselektrode (10) auf dem Substrat, und
Ausführen des Abhebens des verbleibenden Fotolacks zum Ausbilden der Erweiterungselektrode (10).

## Revendications

1. Elément supraconducteur, comprenant :
un pont constitué d'un film mince supraconducteur (2) déposé sur un substrat (1), et
une électrode de commande (3a, 3b; 13a, 13b; 23), qui est connectée à une source de courant externe pour injecter des quasi particules dans le film mince supraconducteur (2),
caractérisé en ce que
on dispose au moins une électrode de commande (3a, 3b; 13a, 13b; 23) qui est constituée d'un film mince métallique ou semi-conducteur et placée de manière à recouvrir partiellement le film mince supraconducteur (2) sur la surface opposée à celle du substrat (1) dans le sens de la largeur du pont constitué par le film mince supraconducteur (2), et en ce que
une extrémité de la dite électrode de commande (3a, 3b; 13a, 13b; 23) est appliquée sur le pont de telle manière qu'il subsiste une partie étroite du pont située à l'intersection avec l'électrode de commande (3a, 3b; 13a, 13b; 23) qui ne soit pas en contact avec l'électrode de commande (3a, 3b; 13a, 13b; 23) dans la direction perpendiculaire à l'axe du courant supraconducteur qui passe dans le pont.

2. Elément supraconducteur, comprenant :
un pont constitué d'un film mince supraconducteur (2) déposé sur un substrat (1), et
une électrode de commande (33a), qui est connectée à une source de courant externe pour injecter des quasi particules dans le film mince supraconducteur (2),
caractérisé en ce que
on dispose une autre électrode de commande (33b),
les deux électrodes de commande (33a, 33b) sont constituées d'un film mince métallique ou semi-conducteur,
une extrémité de chacune des électrodes de commande (33a, 33b) est appliquée sur le pont dans le sens de la largeur du pont constitué par le film mince supraconducteur (2) de telle manière qu'il subsiste une partie étroite du pont située à l'intersection avec les électrodes de commande (33a, 33b) qui ne soit pas en contact avec chacune des extrémités des électrodes de commande (33a, 33b) dans la direction perpendiculaire à l'axe du courant supraconducteur qui passe dans le pont et en ce que
les deux électrodes de commande (33a, 33b) sont reliées électriquement l'une à l'autre par un élément de connexion (33c) de telle sorte que l'élément de connexion (33c) couvre la dite partie étroite du pont et que sa largeur, mesurée dans le sens du courant supraconducteur, est plus étroite que celle des extrémités des électrodes de commande (33a, 33b) non reliées à l'élément de connexion (33c).

3. Elément supraconducteur, comprenant :
un pont constitué d'un film mince supraconducteur (2) déposé sur un substrat (1), et
une électrode de commande (13a), qui est connectée à une source de courant externe pour injecter des quasi particules dans le film mince supraconducteur (2),
caractérisé en ce que
on dispose une autre électrode de commande (13b),
les deux électrodes de commande (13a, 13b) sont constituées d'un film mince métallique ou semi-conducteur,
une extrémité de chacune des électrodes de commande (13a, 13b) est appliquée sur le pont dans le sens de la largeur du pont constitué par le film mince supraconducteur (2) de telle manière qu'il subsiste une partie étroite du pont située à l'intersection entre les électrodes de commande (13a, 13b) qui ne soit pas en contact avec les électrodes de commande (13a, 13b) dans la direction perpendiculaire à l'axe du courant supraconducteur qui passe dans le pont et en ce que
le film mince supraconducteur (2) est déposé sur l'électrode de commande (13a) formée sur le substrat (1) et l'autre électrode de commande (13b) est déposée par dessus le film mince supraconducteur (2).

4. Elément supraconducteur selon la revendication 1, 2 ou 3, comprenant de plus, un film mince isolant déposé entre le pont et l'électrode de commande.

5. Elément supraconducteur selon l'une des revendications 1 à 4, dans lequel le dit film mince supraconducteur (2) est constitué d'un métal tel que le niobium ou le plomb, d'un alliage ou d'un composé métallique.

6. Elément supraconducteur selon l'une des revendications 1 à 5, dans lequel le dit film mince supraconducteur (2) est constitué d'un oxyde supraconducteur de T_{c} élevée.

7. Elément supraconducteur selon la revendication 6, dans lequel le dit oxyde supraconducteur de T_{c} élevée contient des atomes de cuivre.

8. Elément supraconducteur selon la revendication 7, dans lequel le dit oxyde supraconducteur de T_{c} élevée est un oxyde supraconducteur Bi-Sr-Ca-Cu-O.

9. Elément supraconducteur selon la revendication 6, dans lequel le dit oxyde supraconducteur de T_{c} élevée est un oxyde supraconducteur Ba-Pb-Bi-O ou Ba-K-Bi-O

10. Elément supraconducteur selon la revendication 6, dans lequel le dit film métallique ou au moins une partie du dit film métallique faisant contact avec l'oxyde supraconducteur de T_{c} élevée est constitué d'un métal contenant au moins de l'aluminium.

11. Méthode de fabrication d'un élément supraconducteur selon l'une des revendications 1 à 3, comprenant les étapes consistant à :
- former un pont constitué d'un film mince (2) d'un oxyde supraconducteur ou à la fois d'un film mince (2) d'un oxyde supraconducteur et d'un film isolant,
- déposer sur le pont un film mince de résine résistant à la solution de développement de l'agent photorésistant (4),
- appliquer l'agent photorésistant (4) sur le film mince de résine,
- retirer la partie de l'agent photorésistant (4) qui correspond à l'emplacement de l'électrode de commande (3a, 3b; 13a, 13b; 23, 33a, 33b) devant être formée lors d'une procédure ultérieure par exposition et formation du dépôt de l'agent photorésistant (4),
- retirer le film mince de résine exposé en exposant celui-ci à un plasma d'oxygène,
- déposer un film mince métallique ou semi-conducteur (8) sur le substrat (1), puis procéder au décollement de la résine restante (6) et des films minces métalliques (8) pour former les électrodes de commande.

12. Méthode de fabrication d'un élément supraconducteur selon l'une des revendications 1 à 3, comprenant les étapes consistant à :
- déposer un film mince (12) d'un oxyde supraconducteur,
- déposer un film mince métallique ou semi-conducteur (8) sur le film mince (12) d'oxyde supraconducteur dans la même enceinte à vide sans en casser le vide,
- former un pont (9) constitué de la structure en couches des films minces d'oxyde supraconducteur (12) et de métal ou de semi-conducteur (8) en utilisant une technique de gravure ionique sous gaz inerte,
- former une électrode de commande (3a, 3b; 13a, 13b; 23, 33a, 33b) par imagerie sur le film mince métallique ou semi-conducteur (8) dans le pont,
- déposer un film mince métallique ou semi-conducteur (8) sur le substrat, puis
- former un prolongement d'électrode (10) en contact avec l'électrode de commande (3a, 3b; 13a, 13b; 23, 33a, 33b) par la procédure d'imagerie.

13. Méthode de fabrication selon la revendication 12, comprenant de plus, une étape consistant à déposer un film mince isolant après l'étape de dépôt du film mince d'oxyde supraconducteur (12), et avant l'étape de dépôt du film mince métallique ou semi-conducteur (8).

14. Méthode de fabrication selon la revendication 12, dans laquelle la dite étape de formation du prolongement d'électrode (10) comprend les étapes consistant à :
- déposer un film mince métallique, puis
- retirer le film mince métallique à l'exception de la partie correspondant aux prolongements des électrodes en utilisant une technique de gravure ionique sous gaz inerte.

15. Méthode de fabrication selon la revendication 12, dans laquelle la dite étape de formation du prolongement d'électrode (10) comprend les étapes consistant à :
- former un masque de décollement pour former le prolongement d'électrode (10) en utilisant une technique de photolithographie avec un agent photorésistant qui utilise un solvant organique oléophile comme solution de développement,
- déposer un film mince (12) pour le prolongement d'électrode, appliqué sur la surface exposée de l'électrode de commande, puis
- effectuer le décollement de l'agent photorésistant résiduel pour former l'électrode de commande (10).

16. Méthode de fabrication selon la revendication 12, dans laquelle la dite étape de formation du prolongement d'électrode (10) comprend les étapes consistant à :
- déposer un film mince de résine (6) résistant à une solution de développement d'un agent photorésistant (17) devant. être appliqué ultérieurement, sur le film mince supraconducteur (2) et l'électrode de commande (3a, 3b; 13a, 13b; 23, 33a, 33b)
- appliquer l'agent photorésistant (17) sur le film mince de résine (6),
- retirer le film mince de résine (6) par l'exposition et la formation du dépôt, à l'exception de la partie correspondant au prolongement d'électrode (10),
- exposer la partie du film mince de résine (6) à un plasma d'oxygène,
- déposer un film mince (8) sur le substrat pour le prolongement d'électrode (10), puis
- procéder au décollement de l'agent photorésistant résiduel pour former le prolongement d'électrode (10).
